# EUROPÄISCHE PATENTANMELDUNG

(11) **EP 0 696 614 A1**
(43) Veröffentlichungstag der Anmeldung: **14.02.1996**
(21) Anmeldenummer: 95111732.4
(22) Anmeldetag: 26.07.1995
(51) Int. Cl.: C08K 7/02

(54) **Material zur Herstellung elektrisch leitender Verbindungen in thermoplastischen Formkörpern**

(30) Priorität: 08.08.1994 DE 4427983
(71) Anmelder: HOECHST AKTIENGESELLSCHAFT, D-65929 Frankfurt am Main (DE)
(72) Erfinder: Pfeiffer, Bernhard, Dr., D-65779 Kelkheim (DE)

(57) **Zusammenfassung**

Die Erfindung betrifft ein Material zur Herstellung elektrisch leitender Verbindungen in thermoplastischen Formkörpern, das dadurch gekennzeichnet ist, daß das Material einen Thermoplast mit 0,5 bis 30 Vol.-% leitfähigen Fasern einer Länge von 5 bis 20 mm und einem Durchmesser von 5 bis 100 µm enthält und einen spezifischen Durchgangswiderstand unter einem Ohm cm aufweist.

## Beschreibung

Die Erfindung betrifft ein Material zur Herstellung elektrisch leitender Verbindungen in thermoplastischen Formkörpern.

Die Forderung nach Miniaturisierung sowie Produktions- und Effektivitätssteigerung elektrischer Geräte erfordert neue Schaltungskonzepte. Eine wesentliche Verbesserung kann erzielt werden, wenn die Gehäusewandung als Schaltungsträger benutzt wird. Dies setzt voraus, daß die Leiterbahnen zur elektrischen Verbindung der Schaltungselemente auf die Gehäusewandung aufgebracht werden können.

Es ist bekannt, daß Kupferleitungen in den verschiedenen Ausführungen in den Gehäusekunststoff als Einlegeteil eingespritzt (Insert-Technik) oder aufgelegt werden können. Dies ist jedoch aufwendig, da beim Umformprozeß komplexe Einlegeteile verwendet werden müssen. Der konventionellen Herstellung von Leiterplatten ähnlich sind Verfahren, bei denen zuerst vollständig die Gehäuseinnenseite galvanisiert wird. Anschließend wird mit einem Photoresist beschichtet und durch verschiedene Beleuchtungstechniken (Masken, Laser) mit nachfolgender Entwicklung (Ätzen) das Leitungsbild strukturiert. Vorteilhaft sind Zwei-Komponenten-Spritzgießverfahren (vgl. EP-PS 564019-A2, 323685-A, 256428-A), bei denen zuerst das Leiterbild mittels eines metallisierbaren Kunststoffes abgespritzt wird. Dann muß der Kunststoff allerdings nach verschiedenen aufwendigen Methoden vorbehandelt (z.B. Pd-bekeimt) werden. Im dritten Schritt werden die Räume zwischen den Leiterbahnen aufgefüllt. Anschließend wird an der Oberfläche des vorbehandelten Materials stromlos Kupfer oder Nickel abgeschieden. In weiteren Schritten lassen sich auf diesen Schichten zusätzliche Metallagen aufbringen. Diese Verfahren erfordern eine sehr gute Haftung des Metalls auf dem Kunststoff. Zur Haftungssteigerung ist eine aufwendige, teure und umweltbelastende Vorbehandlung Voraussetzung. Zudem bestehen die Verfahren aus einer Anzahl von unterschiedlichen Einzelschritten, die nur schwer automatisiert werden können.

Der Erfindung liegt die Aufgabe zugrunde, beim Spritzgußprozeß ein Material einzusetzen, mit dem das Leiterbild ohne Nachbehandlung mit dem Gehäuse zusammen abgespritzt werden kann.

Erfindungsgemäß wird die Aufgabe durch ein Material gelöst, das einen faserverstärkten Thermoplast mit 0,5 bis 30 Vol.-% leitfähigen Fasern in einer Länge von 5 bis 20 mm und einem Durchmesser von 5 bis 100 µm enthält und das einen spezifischen Durchgangswiderstand von unter 1 Ohm·cm aufweist. Zweckmäßige Ausgestaltungen werden in Ansprüchen 2 bis 6 angegeben.

Mit dem erfindungsgemäßen Material ist es möglich, daß die Leiterbahnen entweder gleichzeitig mit dem Gehäuse gespritzt (Zwei-Komponenten-Spritzguß) oder separat abgespritzt und als Einlegeteil beim Abspritzen des Gehäuses zugegeben werden. Das Material gestattet eine schnelle "Verkabelung" schon bei der Herstellung des Gehäuses. Zur Kontaktierung der elektrischen Komponenten des Geräts (z.B. eines Motors) mit den Leiterbahnen müssen Kontakte als Einlegeteil in Form von Stiften, Ösen, Innengewinden oder Lötfahnen in die Leiterbahnen eingespritzt oder nachträglich über selbstschneidende Schraubgewinde eingedreht oder eingepreßt werden. Auch das Aufkleben der Kontakte von elektrischen Komponenten mit leitfähigen Klebern ist möglich. Zusätzliche Schritte sind nicht erforderlich. In Anschluß an die Herstellung des Gehäuses kann dieses mit den elektrischen Komponenten bestückt werden.

Das Material weist eine ausreichende Leitfähigkeit und hohe mechanische Zähigkeit (Verformung des Gehäuses ohne Riß der Leiterbahnen) auf und ist thermoplastisch verarbeitbar (z.B. für Spritzguß). Es können Thermoplaste im weitesten Sinne, d.h. Stoffe, die sich reversibel oder intermediär thermoplastisch verhalten, eingesetzt werden. Der Matrixthermoplast muß einen niedrigeren Erweichungs- bzw. Schmelzpunkt besitzen als die leitfähigen Fasern und eventuell vorhandene leitfähige und nicht leitfähige Füllstoffe. Als leitfähige Füllstoffe können Metallpulver, beispielsweise aus Eisen, Stahl, Kupfer, Aluminium, Nickel usw., aber auch Leitruße verwendet werden. Die leitfähigen Fasern können u.a. Metallfasern aus Eisen, Stahl, Kupfer, Aluminium, Nickel und/oder Kohlefasern darstellen. Auch Gemische verschiedener leitfähiger Füllstoffe sind möglich. Besonders bevorzugt werden sehr lange und dünne Edelstahlfasern. Auch der Einsatz von metallisierten Glas ist möglich. Metallfasern können im Kombination mit Kohlefasern oder Leitrußen eingesetzt werden. Die verwendeten langen und dünnen Fasern bilden schon bei geringen Faseranteilen ein Netzwerk, welches in Fließrichtung eine hohe Leitfähigkeit aufweist. Vorteilhaft wird durch den Einsatz von nichtleitenden Füllstoffen die Leitfähigkeit erhöht. Bei Verwendung von kurzen bzw. langen Glasfasern wird zusätzlich die mechanische Festigkeit und Steifigkeit erhöht. Die Faserlänge der Kurzglasfaserverstärkung liegt unter 0,5 mm, wogegen bei Langglasfaserverstärkung Faserlängen über 0,5 mm, bevorzugt im Bereich von 5 bis 20 mm erreicht werden. Der Gehalt an nichtleitenden Füllstoffen beträgt 0 bis 50 Vol.-%, bevorzugt 0 bis 10 Vol.-%.

Besonders vorteilhaft ist der Einsatz des erfindungsgemäßen Materials dort, wo Verkabelungen in großer Stückzahl vorgenommen werden müssen, beispielsweise in der Konsumgüterindustrie oder auf engstem Raum, wie z.B. im Bereich der Telekom. Die Erfindung betrifft insbesondere die Verwendung des Materials zur Herstellung von Leiterbahnen. Bei diesen Leiterbahnen ist das Verhältnis Länge/Breite der Bahnen mindestens 5 und vorzugsweise mindestens 10. Vorzugsweise enthalten die hergestellten Bauteile mindestens zwei Leiterbahnen.

Die Erfindung wird anhand der nachfolgenden Beispiele näher erläutert.

### Beispiel 1:

Die Geometrie von Leiterbahnen wurde durch das Abspritzen von Fließspiralen simuliert (Querschnitt 5 x 2 mm², Fließweglänge 50 bis 100 cm).

Als Thermoplast wurde ein Polyamid 66 verwendet, dem ca. 11 mm lange Stahlfasern mit 8 µm Durchmesser in verschiedenen Konzentrationen zugesetzt wurden. Zusätzlich wurden bei einzelnen Experimenten Leitruß, Kohlefasern oder Kurzglasfasern zugesetzt.

| | |
|---|---|
| A. PA 66-SF 10: | 10 Gew.-% (1.4 Vol.-%) Edelstahlfasern |
| B. PA 66-SF 20: | 20 Gew.-% Edelstahlfasern |
| C. PA 66-SF 10/Leitruß: | wie A, zusätzlich Leitruß (10 Gew.-%) |
| D. PA 66-SF 10/Kohlefasern: | wie A, zusätzlich Kohlefasern (10 Gew.-%) |
| E. PA 66-SF 10/kGF: | wie A, zusätzlich Glasfasern (28 Gew.-%) |

Die Widerstände in Spritzrichtung wurden mit einem Multimeter gemessen und über den Querschnitt der Fließspirale und den Abstand der Schrauben die spezifischen Widerstände errechnet.

Die Fließspiralen wurden in 10 cm lange Stücke zerschnitten und die spezifischen Widerstände in Abhängigkeit von der Fließweglänge bestimmt und statistisch ausgewertet. Diese Werte sind in Tabelle 1 aufgeführt.

Von den 10 cm-Stücken wurden die Fasergehalte durch Veraschen bestimmt. Hierzu wurde die Polymermatrix in einem Muffelofen bei ca. 500°C verdampft. Durch Differenzwägung wurde der Gewichtsverlust ermittelt und dieser auf den Fasergehalt umgerechnet.

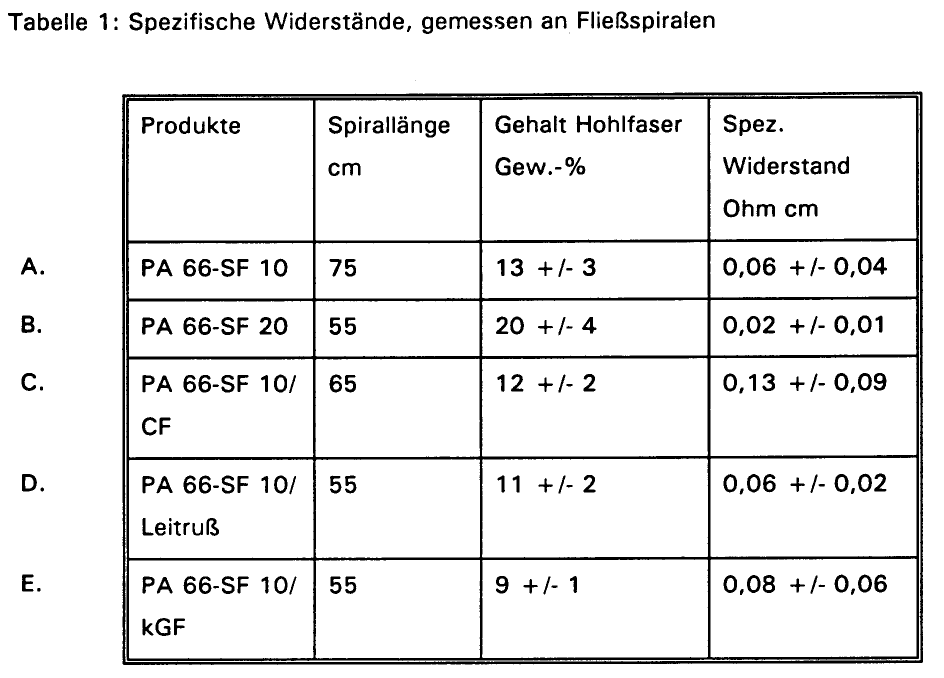

### Beispiel 2

Fließspiralen aus Beispiel 1E (PA 66-SF 10/kGF) wurden über selbstschneidende Metallschrauben kontaktiert, die in den Kern des Materials zur Kontaktierung eingedreht wurden, und als Widerstand-Heizspirale über mehrere Wochen betrieben.

| | |
|---|---|
| Spirallänge (Abstand Kontakte): | 55 cm |
| Spannungsabfall: | 13 V |
| Stromstärke: | 0,5 A |
| Temperatur: | 60 bis 100°C |

## Patentansprüche

1. Material zur Herstellung elektrisch leitender Verbindungen in thermoplastischen Formkörpern, dadurch gekennzeichnet, daß das Material einen Thermoplast mit 0,5 bis 30 Vol.-% leitfähigen Fasern einer Länge von 5 bis 20 mm und einem Durchmesser von 5 bis 100 µm enthält und einen spezifischen Durchgangswiderstand unter einem Ohm cm aufweist.

2. Material gemäß Anspruch 1, dadurch gekennzeichnet, daß es 0 bis 50 Vol.-% insbesondere 0 bis 10 Vol.-% nichtleitende Füllstoffe enthält.

3. Material gemäß Anspruch 1, dadurch gekennzeichnet, daß die leitfähigen Fasern aus Metallfasern, bevorzugt Stahlfasern, aus metallisierten Glasfasern und/oder Kohlenstoffasern bestehen.

4. Material gemäß Anspruch 1, dadurch gekennzeichnet, daß es einen pulverförmigen leitfähigen Füllstoff, insbesondere Leitruß, enthält.

5. Material gemäß Anspruch 2, dadurch gekennzeichnet, daß die nichtleitenden Füllstoffe aus Kurzglasfasern bis 0,5 mm Länge oder Langglasfasern von 5 bis 20 mm Länge bestehen.

6. Verwendung des Materials gemäß den Ansprüchen 1 bis 5 zur Herstellung von Leiterbahnen.
